# EUROPEAN PATENT SPECIFICATION

(11) **EP 2 881 952 B1**
(45) Date of publication and mention of the grant of the patent: **26.10.2016**
(21) Application number: 14190282.5
(22) Date of filing: 24.10.2014
(51) Int. Cl.: H01B 1/22

(54) **CONDUCTIVE PASTE FOR SOLAR CELL AND THE METHOD THEREOF**
LEITFÄHIGE PASTE FÜR EINE SOLARZELLE UND VERFAHREN DAFÜR
PÂTE CONDUCTRICE POUR CELLULE SOLAIRE ET SON PROCÉDÉ

(30) Priority: 25.10.2013 TW 102138618
(43) Date of publication of application: 10.06.2015
(73) Proprietor: Giga Solar Materials Corporation, Hsinchu County 303 (TW)
(72) Inventor: Shih, Po-Yang, 303 Hsinchu County (TW); Tsou, Da-Yi, 303 Hsinchu County (TW); Yeh, Chih-Hsien, 303 Hsinchu County (TW); Shen, Jen-Ren, 303 Hsinchu County (TW); Tseng, Peng-Sheng, Hsinchu County 303, Taiwan, R.O.C. (TW)
(74) Representative: Zaboliene, Reda

(56) References cited:
- EP-A1- 2 317 523
- EP-A1- 2 654 085
- EP-A1- 2 654 086

## Description

### TECHNICAL FIELD

The present invention generally relates to a conductive paste, more particularly, to a conductive paste applied to a solar cell for enhancing the conversion efficiency thereof.

### BACKGROUND

Solar power is a progressing development of industry, and has gradually emerged from the application of energy industry. The current international oil prices steadily rising, global oil resources are limited, and with the Kyoto Protocol for the reduction of emissions environmental awareness, the traditional burning of oil, coal and other power generation is restricted. Therefore, the world's major countries actively research and develop in recent years in order to clean renewable energy sources to replace fossil fuels in order to reduce the pollution problems arisen from traditional power generation. In alternative energy, in the advanced countries, whether it is solar, wind, geothermal, biomass, etc., are to promote common objectives, which, especially in the application of solar energy demand is strongest. According to research firm Solarbuzz Solar survey shows that in the past two decades, the demand for solar photovoltaic shows upward trend. For installed capacity of solar photovoltaic systems, the global installed capacity from the period 2001 to 2006, rises from 340MW to 1,744 MW, 5 years of growth more than five times, and the average annual increases of about 39%. Solar power in the foreseeable future human energy use is to play an increasingly important role.

Solar cells are devices capable of converting light energy into electrical energy, which are generally made on semiconductor materials, such as mono-crystalline silicon, polycrystalline and amorphous substrates, or compound semiconductors such as GaAs, GaP, InP, AlGaAs, etc group □, □ element compound substrate. For silicon substrates, light-receiving area (positive side) of the P-type silicon substrate is in general doped with phosphorus atoms to form a negative electrode, while back side of non-light receiving area is a corresponding positive electrode. A specific wavelength (λ) of incident light enters into PN junction formed on semiconductor substrate for converting into electron-hole pairs moving to the opposite direction of two electrodes to produce a current which is a power source of solar cell. Generally, an antireflection film (e.g., silicon nitride SiNx film) is coated on the light receiving surface of silicon substrate to prevent energy loss caused by reflection of light to increase the conversion efficiency of solar cells (Eff%). In addition to the semiconductor substrate of solar cell, an aluminum back surface field (BSF, back surface field) layer is in general formed on the back side of silicon substrate after the formation of PN interface. Aluminum back surface field can be facilitated to reduce the probability of recombination of the minority carriers (electron, hole) at back side, which can also be used as a back side electrode, and thereby improving the conversion efficiency of solar cells. The easiest way to produce the aluminum back surface field is coating a layer of aluminum film and then sintering aluminum atoms for aluminum diffusion into the silicon substrate to form a high aluminum-doped (Al-dopant) concentration P + layer.

Moreover, a current may be conducted by the two metal electrode terminals of the semiconductor substrate to the external load side such that the current generated by the solar cell is conducted out as an available electrical energy. Of course, the metal electrode will block the light-receiving side (ie, positive side) of the substrate to impede the absorption of sunlight, so an area of the metal electrode on the positive side of solar cells is as small as possible to increase the photo-receiving area of the solar cells. Therefore, the metal electrodes are generally made on positive/back side of the solar cells as mesh electrode structure by using screen printing technology. In electrode manufacturing, a conductive metal paste (conductive paste) is printed on doped silicon substrate in accordance with the designed graph by using screen printing technology. Organic solvents in the conductive metal paste is volatilized in an available sintering condition such that metal particles interact with the surface of silicon to form silicon alloy as a good ohmic contact, and thus become a positive and back metal electrode of the solar cells. However, too thin electrode finger line could easily lead to the disconnection, or resistance increased, reducing the conversion efficiency of the solar cells. Therefore, it is the technical focus how to achieve the thinning without reducing the overall power efficiency of the cells. In general, the thickness of the metal electrode is about 10 to 25 microns (um), and the width of the positive metal line (finger line) is approximately 120-200 microns. It has advantages of automation, high throughput and low cost by using such technology to produce the electrodes of the solar cells.

As above-mentioned, in addition to the formation of the P-N junction semiconductor substrate, the main part of manufacturing the solar cells is the conductive paste. The composition, content, proportion, process parameters will affect the performance of the final electrode product. Take positive side metal electrode for example, quality of the conductive paste will be directly impact to the conversion efficiency (Eff%), open circuit voltage (Voc), short circuit current (Isc), fill factor (F.F.), series resistance (Rs), and shunt resistance (Rsh) of the solar cell, and will determine the effective range of sintering temperature Ts and adhesion strength. Therefore, how to deploy a conductive paste to improve performance of solar cell is dominate for the industry developments.

The conductive paste in prior arts is generally added containing lead materials, such as lead oxide (PbO). Lead oxide added may achieve many excellent effects, such as reducing sintering temperature of the conductive paste, reducing the contact resistance between conductive paste and semiconductor substrate. Currently, the industry is actively seeking to develop new composition of conductive paste, in order to produce a solar cell having superior performance.

### SUMMARY OF THE INVENTION

The purpose of the invention is to form front-side electrode of the substrate for solar cell, whereby enhancing the performance of Ohmic contact, fill factor and conversion efficiency of the solar cell, after sintering. The front-side electrode of the substrate for solar cell is made of conductive paste.

According to an aspect, the invention provides a conductive paste, comprising the following composition: conductive metal and glass frit. The glass frit includes a glass frit (I) which includes bismuth oxide, tellurium oxide, tungsten oxide, silicon oxide, and zinc oxide, and a glass frit (II) which includes lead oxide, tellurium oxide, and zinc oxide. The conductive paste is utilized to form an electrode of a substrate for a solar cell to enhance the performance of conversion efficiency of the solar cell.

The percentage by weight of bismuth oxide, tellurium oxide, tungsten oxide, silicon oxide, and zinc oxide in the glass frit (I) is about 35∼70, 0.1∼25, 1∼28, 1∼28, and 0.1∼20, respectively. The percentage by weight of lead oxide, tellurium oxide, and zinc oxide in the glass frit (II) is about 10∼45, 54∼89, and 0.1∼10, respectively. In one preferred embodiment, bismuth oxide, tellurium oxide, tungsten oxide, silicon oxide, and zinc oxide of the glass frit (I) are Bi₂O₃, TeO₂, WO₃, SiO₂, and ZnO, respectively, and lead oxide, tellurium oxide, and zinc oxide of the second glass frit (II) are PbO, TeO₂, and ZnO, respectively.

The glass frit (I) further includes at least one element or its oxide consisting of: Sn, P, F, Li, Ba, Al, Mg, Ti, Zr, Pb, V, Se, Mo, W, Ni, Ag, Er, Ge, Ga, Ce, Nb, Sm, and La, of which percentage by weight in the glass frit (I) is 0.1∼3. The glass frit (II) may further include at least one element or its oxide consisting of: P, Ba, Al, Mg, Ti, Zr, V, Se, Ag, Er, Yb, Ge, Ga, Ce, Nb, Bi, and Li, of which percentage by weight in the glass frit (II) is 0∼10.

The conductive paste may be incorporated with an organic vehicle and an additive. The additive may be selected from the group consisting of ZrO₂, V₂O₅, Ag₂O, Er₂O₃, SnO, MgO, Nd₂O₃, TiO₂, SeO₂, PbO, Cr₂O₃, K₂O, P₂O₅, MnO₂, NiO, Sni₂O₃, GeO₂, ZnF₂, In₂O₃, Ga₂O₃, and the derivative thereof.

According to another aspect, the invention provides a method for manufacturing a conductive paste, comprising the following steps, providing a vehicle. A conductive metal is provided. The glass frit (I) which includes bismuth oxide, tellurium oxide, tungsten oxide, silicon oxide, and zinc oxide is prepared, and a glass frit (II) which includes lead oxide, tellurium oxide, and zinc oxide is also prepared. The vehicle, the conductive metal powder, the glass frit (I), and the glass frit (II) are mixed to form the conductive paste. Chemical composition and the content ratio of each of the components can refer to the above-mentioned.

One advantage of the invention is that the manufactured conductive paste can be sintered at low sintering temperature, and then the positive (front-side) electrode of solar cell could be facilitated to achieve high conversion efficiency at low sintering temperature, and to achieve energy saving effect.

Another advantage of the invention is that the conductive paste is utilized to form the front-side electrode of solar cell with a high performance of conversion efficiency.

The components, characteristics and advantages of the present invention may be understood by the detailed descriptions of the preferred embodiments outlined in the specification.

### DETAILED DESCRIPTION

Some preferred embodiments of the present invention will now be described in greater detail. However, it should be recognized that the preferred embodiments of the present invention are provided for illustration rather than limiting the present invention. In addition, the present invention can be practiced in a wide range of other embodiments besides those explicitly described, and the scope of the present invention is not expressly limited except as specified in the accompanying claims.

The invention provides a conductive paste capable of enhancing performance of conversion efficiency of solar cell. In one embodiment, the conductive paste may be formed as a front-side electrode (light-receiving side) of the substrate of solar cell. The proposed conductive paste can be sintered at low sintering temperature, whereby the manufactured solar cell has high conversion efficiency. The preferred embodiments of the invention are provided for illustration rather than limiting the invention.

To achieve the above-mentioned purpose, the proposed conductive paste generally comprises a conductive metal powder, a glass frit (I), a glass frit (II), and an organic vehicle, and also additives (if necessary). Silver is a very good medium for conductive. In an embodiment of the invention, silver particles which contain shape of spherical, flake or both can be used. The speed of sintering for conductive paste will be influenced by particle size of silver. In general, the greater the silver particles are, the slower the sintering speed is. Larger silver particles are prone to the phenomenon of incompletely sintering to cause conductivity and strength of the electrode lower, while the smaller particles are to make rapidly sintering on some areas, and cause interfaces of silver and the other ingredients for cracks. In this embodiment of the invention, size distribution of diameter of the silver particles is optimized to about 0.1 ∼ 10.0 microns (µm). In all embodiments, the percentage by weight of silver is not specifically limited as long as the proportion of silver in conductive paste can achieve the purpose of the invention. However, in the embodiment, the proportion of silver is preferably approximately 60 ∼ 90 wt% (weight percentage) by overall conductive paste. Moreover, powder of silver is an example of conductive metal in this embodiment, but not limited, and any other conductive metal elements, alloys, or mixtures can be used in this invention.

The embodiment of the conductive paste comprises a glass frit (I), which further includes bismuth oxide, tellurium oxide, tungsten oxide, silicon oxide, and zinc oxide, and a glass frit (II), which further includes lead oxide, tellurium oxide, and zinc oxide, to enhance the performance of conversion efficiency of solar cell. The bismuth oxide, tellurium oxide, tungsten oxide, silicon oxide, and zinc oxide of the glass frit (I) include but not limited to Bi₂O₃, TeO₂, WO₃, SiO₂, and ZnO, respectively. The lead oxide, tellurium oxide, and zinc oxide of the glass frit (II) include but not limited to PbO, TeO₂, and ZnO, respectively. It should be noted that, for person skilled in the art, the metal-oxide or non-metal oxide with different valence number may also be used. The percentage by weight of glass frits is not specifically limited as long as the proportion of glass frits in conductive paste can achieve the purpose of the invention. However, in the embodiment, the proportion of glass frit is preferably approximately 0.1∼10 wt% (weight percentage) by overall conductive paste. Also, on the percent composition of the glass frit (I), percentage by weight of bismuth oxide (such as Bi₂O₃) is preferable 35∼70; of tellurium oxide (such as TeO₂) is preferable 0.1-25; of tungsten oxide (such as WO₃) is preferable 1-28; of silicon oxide (such as SiO₂) is preferable 1∼28; and of zinc oxide (such as ZnO) is preferable 0.1∼20. And on the percent composition of the glass frit (II), percentage by weight of lead oxide (such as PbO) is preferable 10∼45; of tellurium oxide (such as TeO₂) is preferable 54-89; and of zinc oxide (such as ZnO) is preferable 0.1∼10.

In one embodiment, the glass frit (I) further includes at least one element or its oxide consisting of: Sn, P, F, Li, Ba, Al, Mg, Ti, Zr, Pb, V, Se, Mo, W, Ni, Ag, Er, Ge, Ga, Ce, Nb, Sm, and La, of which percentage by weight in the first glass frit (I) is 0.1∼3. In another embodiment, the glass frit (II) may further include at least one element or its oxide consisting of: P, Ba, Al, Mg, Ti, Zr, V, Se, Ag, Er, Yb, Ge, Ga, Ce, Nb, Bi, and Li, of which percentage by weight in the glass frit (II) is 0∼10.

In one embodiment, organic vehicle may be formed by mixing organic solvent with resin. Organic solvent may comprise two or more solvents, for example, Butyl Carbitol DB, alpha-Terpineol, and/or Texanol. Resin may also comprise two or more celluloses with different molecular weight, for example, Ethyl cellulose or mixture thereof. In all embodiments, the percentage by weight, recipe, or compositions of the organic vehicle is not specifically limited as long as the proportion of organic vehicle in conductive paste can achieve the purpose of the invention. However, in this embodiment, the proportion of organic vehicle is preferably approximately 10∼30 wt% (weight percentage) by overall conductive paste.

Moreover, additives may be added into conductive paste of the invention depending on various requirements. The additives comprise, for example, dispersant, leveling agent, thixotropic agent, stabilizer, viscosity adjuster, and surfactant. The proportion of additives is preferably approximately 0∼5 wt% (weight percentage) by overall conductive paste. The main function of additives is to adjust the viscosity and wettability of the conductive paste and uniformly dispersing particles, and to enhance the tightness and conductivity of metal particles after sintering. Therefore, two or more kinds of the additives may be added to achieve better performances.

In one embodiment, the conductive paste may be incorporated with one or more additives which may be selected from the group consisting of ZrO₂, V₂O₅, Ag₂O, Er₂O₃, SnO, MgO, Nd₂O₃, TiO₂, SeO₂, PbO, Cr₂O₃, K₂O, P₂O₅, MnO₂, NiO, Sm₂O₃, GeO₂, ZnF₂, In₂O₃, Ga₂O₃, and the derivative thereof.

Further embodiments related to the glass frits are described below. Various percent compositions of the glass frit (I) are shown in table 1, and various percent compositions of the glass frit (II) are shown in table 2. A1∼A7 of table 1 indicate different compositions including Bi₂O₃, TeO₂, WO₃, SiO₂, ZnO, and PbO. B1∼B7 of table 2 indicate different compositions including PbO, TeO₂, ZnO, Li₂O, P₂O₅, and Bi₂O₃.

**Table 1**

| Wt% | A1 | A2 | A3 | A4 | A5 | A6 | A7 |
|---|---|---|---|---|---|---|---|
| Bi₂O₃ | 30 | 55 | 50 | 55 | 64 | 58 | 47 |
| TeO₂ | 18 | 22 | 12 | 13 | 3 | 9 | 15 |
| WO₃ | 22 | 5 | 15 | 9 | 10 | 7 | 16 |
| SiO₂ | 20 | 3 | 12 | 7 | 5 | 12 | 12 |
| ZnO | 10 | 13 | 8 | 16 | 17 | 12 | 7 |
| PbO | - | 2 | 3 | - | 1 | 2 | 3 |

**Table 2**

| Wt % | B1 | B2 | B3 | B4 | B5 | B6 | B7 |
|---|---|---|---|---|---|---|---|
| PbO | 18 | 25 | 32 | 38 | 20 | 45 | 35 |
| TeO₂ | 76 | 74 | 65 | 57 | 70 | 50 | 62 |
| ZnO | 2 | 0.1 | 3 | 2 | 6 | 5 | 2 |
| Li₂O | 1 | | - | - | 2 | - | 1 |
| P₂O₅ | 1 | 1 | - | - | 1 | - | - |
| Bi₂O₃ | 2 | - | - | 3 | 1 | - | - |

In these embodiments, each composition of the glass frit (I) (A) in Table 1 and each composition of the glass frit (II) (B) in Table 2 are selected for mixing to form the conductive paste. The experimental results indicate that combined glass frits, i.e. a mixture of the glass frit (I) and the glass frit (II), have better Performance. Refer to the contrasts 1 and 2 of Table 3, the conversion efficiency (NCell) of solar cell is lower than 14% when alone uses the glass frit (I) or the glass frit (II). On the contrary, in this invention, the conversion efficiency of each embodiment in Table 3 is nearly 18% when employs the mixture of the glass frit (I) and the glass frit (II), which has significantly increasing of about 4% conversion efficiency. Based on the experiment result, mixture of A3 of Table 1 (glass frit (I)) and B7 of Table 2 (glass frit (II)) has the best electrical performance. In the further embodiments as shown in Table 3, ratios of A3 and B7 is approximately as follows: A3 is 0% ∼ 4%, B7 is 0% ∼ 4% (a percentage by weight in the conductive paste, where ratio of "0%" indicates that only the other kind of the glass frit is used), for example, A3 is percentage by weight of 3.2%, B7 is percentage by weight of 0.8%. Table 3 shows the performance of the conductive paste sintered at 920 °C in each experiment (hereinafter referred to as "Exp" in Table 3), wherein Contrast 1 uses A3 alone, Contrast 2 uses B7 alone, and Exp 1-5 use mixtures of A3 and B7 combined in different ratios.

**Table 3**

| | glass frit in the conductive paste (wt%) | | Performance | | | | |
|---|---|---|---|---|---|---|---|
| | A3 | B7 | Voc | Isc | Rs | FF | NCell |
| Contrast 1 | 4 | 0 | 0.6205 | 8.66 | 0.01805 | 61.4 | 13.56 |
| Contrast 2 | 0 | 4 | 0.6218 | 8.67 | 0.01658 | 62.6 | 13.86 |
| Exp 1 | 2.8 | 1.2 | 0.6271 | 8.74 | 0.00260 | 78.6 | 17.70 |
| Exp 2 | 2.3 | 1.7 | 0.6283 | 8.74 | 0.00259 | 78.9 | 17.81 |
| Exp 3 | 1.8 | 2.2 | 0.6284 | 8.73 | 0.00249 | 78.8 | 17.77 |
| Exp 4 | 3.2 | 0.8 | 0.6290 | 8.74 | 0.00249 | 790 | 17.85 |
| Exp 5 | 1.2 | 2.8 | 0.6293 | 8.74 | 0.00274 | 78.9 | 17.83 |

In further embodiments, to identify the effects of all sub glass frit series, each combination of Table 1 and Table 2 is mixed for an advanced test based on the best NCell result of Table 3, i.e. Exp 4, where the percentage ratio of glass frits (I) and (II) is 3.2:0.8 (wt %), thus the A3 of glass frit (I) is set as a fixed parameter, and each B of glass frit (II) is set to a variable, as shown in Table 4,and the B7 of glass frit (II) is set as a fixed parameter, and each A of glass frit (I) is set to a variable, as shown in Table 5. In other words, A3 is fixed in Table 4, and B is a variable from B1 to B7;, on the contrary, B7 is fixed in Table 5, and A is a variable from A1 to A7. The resulting experimental data is listed in Table 4 and Table 5.

**Table 4**

| | glass frit in the conductive paste (wt%) | | Performance | | | | |
|---|---|---|---|---|---|---|---|
| Glass B | A3 | B | Voc | Isc | Rs | FF | NCell |
| B1 | | | 0.6292 | 8.78 | 0.00313 | 78.4 | 17.80 |
| B2 | | | 0.6276 | 8.73 | 0.00252 | 78.7 | 17.72 |
| B3 | | | 0.6267 | 8.74 | 0.00272 | 78.5 | 17.68 |
| B4 | 3.2 | 0.8 | 0.6289 | 8.74 | 0.00280 | 78.6 | 17.75 |
| B5 | | | 0.6280 | 8.74 | 0.00268 | 78.8 | 17.78 |
| B6 | | | 0.6275 | 8.74 | 0.00261 | 78.8 | 17.75 |
| B7 | | | 0.6290 | 8.74 | 0.00249 | 79.0 | 17.85 |

**Table 5**

| | glass frit in the conductive paste (wt%) | | Performance | | | | |
|---|---|---|---|---|---|---|---|
| Glass A | A | B7 | Voc | Isc | Rs | FF | NCell |
| A1 | | | 0.6256 | 8.70 | 0.00272 | 78.5 | 17.57 |
| A2 | | | 0.6280 | 8.73 | 0.00255 | 79.0 | 17.79 |
| A3 | | | 0.6290 | 8.74 | 0.00249 | 79.0 | 17.85 |
| A4 | 3.2 | 0.8 | 0.6274 | 8.81 | 0.00275 | 78.6 | 17.84 |
| A5 | | | 0.6271 | 8.81 | 0.00294 | 78.4 | 17.79 |
| A6 | | | 0.6282 | 8.77 | 0.00316 | 78.4 | 17.76 |
| A7 | | | 0.6288 | 8.76 | 0.00309 | 78.5 | 17.77 |

The conversion efficiency of solar cell (NCell) is the most important indicator, which relates to the proportion of the received light converted to energy available for use. A fill factor (FF) is the result of dividing maximum power point (MPP) (i.e. the maximum power of output) by open-circuit voltage (Voc) and short circuit current (Isc). The open-circuit voltage is a voltage measurement of solar cell under infinite load (that is, an open external circuit), and then the output current is zero. Short-circuit current is the output current of solar cell under non-load state (that is, when an external circuit is open), and then the output voltage is zero. Under ideal condition, the short-circuit current of solar cell is equal to the current generated by the illumination. Open-circuit voltage and short-circuit current relate to the maximum power point of solar cell. Generally, the higher open-circuit voltage and short-circuit current of solar cell are, the more generated output power is. For a high-efficiency solar cell, besides higher values of open-circuit voltage and short circuit current, it's also crucial to have a fill factor as close to 1 as possible. Since the fill factor indicates the proportion of the maximum output power to the product of Voc and Isc. A FF closer to 1 means a realistic maximum output power closer to the theoretical value of multiplying open-circuit voltage and short-circuit current.

Based-on the proposed two or more glass frit series in different proportions, a embodied silver conductive paste of this invention as a positive side electrode of solar cell after sintering can make solar cells having a good ohmic contact, a higher fill factor (FF), and a better performance of conversion efficiency (Eff%). In other words, the conductive paste comprising the glass frit (I) (containing bismuth oxide, tellurium oxide, tungsten oxide, silicon oxide, and zinc oxide) and the glass frit (II) (containing lead oxide, tellurium oxide, and zinc oxide) may have enhanced properties on ohmic contact, fill factor, and performance of conversion efficiency.

The following examples describe a method of manufacturing the conductive paste. It should be noted that all (including but not limited to) the preparation method, proportion of component, usage, experimental parameters are only for illustrating embodiments of the invention, but not limited to the invention and not to limit the claims of the invention. Firstly, an organic vehicle is prepared, wherein 5 to 25 grams of ethyl cellulose (EC) is dissolved into 5 to 75 grams of organic solvent. The organic solvent used in this embodiment is glycol ether, but is not limited to use only in such an organic solvent; in other embodiments, other organic solvents may be used, such as alcohol ethers or solvent-soluble cellulose resins. In this embodiment, boiling point of the solvent is about 120 ∼ 300 □. Additives can be added into the organic vehicle, the additives are functional additives, for example, dispersant, leveling agent, thixotropic agent, stabilizer, viscosity adjuster or surfactant. Then, 70 to 95 grams of commercially available silver powder, 10 to 30 grams of the organic vehicle and 1 to 10 grams of glass frits (including the glass frits (I) and (II)) are mixed, and followed by using a three-roll mill to facilitate evenly mixing and dispersing to obtain a paste mixture as the conductive paste.

Next, the conductive paste is screen printed onto the front side of a substrate of solar cell, wherein surface of the substrate is pre-treatment with a silicon nitride for antireflection. Back side electrode is formed by aluminum paste which is GSMC A136 aluminum paste. Drying temperature and time after screen printing may vary depended on weight of printed material and selected organic solvent of the conductive paste, wherein the drying temperature is about 100 ∼ 250 °C, and the drying time is about 5 to 30 minutes. After screen printing of front side and back side conductive paste is completed, the conductive paste is sintered by an infrared conveyor belt sintering furnace which the sintering temperature can be adjusted between 850 ∼ 980 □. After sintering, the conductive paste is formed as solid electrodes on front side and back side of the substrate. After the electrodes are made, electrical testing for solar cell is performed by a solar cell tester. The electrical characteristics of solar cell are measured under AM1.5G condition.

In summary, this embodiment proposes a method of manufacturing a conductive paste, wherein the content and chemical composition of each component may refer to the recipe of the preceding embodiments.

## Claims

1. A conductive paste, which characterizes in that it comprises:
a conductive metal;
a glass frit (I), which includes 35∼70 wt % bismuth oxide, 0.1∼25 wt % tellurium oxide, 1∼28 wt % tungsten oxide, 1∼28 wt % silicon oxide, and 0.1∼20 wt % zinc oxide; and
a glass frit (II), which includes 10∼45 wt % lead oxide, 54∼89 wt % tellurium oxide, and 0.1∼10 wt % zinc oxide,
wherein said conductive paste is utilized to form an electrode on a substrate of a solar cell to enhance the conversion efficiency.

2. The conductive paste of claim 1, wherein said glass frit (I) further includes at least one element or its oxide consisting of: Sn, P, F, Li, Ba, Al, Mg, Ti, Zr, Pb, V, Se, Mo, W, Ni, Ag, Er, Ge, Ga, Ce, Nb, Sm, and La, of which percentage by weight in the glass frit (I) is 0.1∼3.

3. The conductive paste of claim 1, wherein said glass frit (II) may further include at least one element or its oxide consisting of: P, Ba, Al, Mg, Ti, Zr, V, Se, Ag, Er, Yb, Ge, Ga, Ce, Nb, Bi, and Li, of which percentage by weight in the glass frit (II) is 0∼10.

4. The conductive paste of claim 1, wherein said bismuth oxide, said tellurium oxide, said tungsten oxide, said silicon oxide, and said zinc oxide of said glass frit (I) are Bi₂O₃, TeO₂, WO₃, SiO₂, and ZnO, respectively; and said lead oxide, said tellurium oxide, and said zinc oxide of said glass frit (II) are PbO, TeO₂, and ZnO, respectively.

5. The conductive paste of claim 1, which further comprises an organic vehicle and an additive.

6. A method for manufacturing a conductive paste, which characterizes in that comprises:
(a) providing a vehicle;
(b) providing a conductive metal;
(c) preparing a glass frit (I) which includes 35∼70 wt % bismuth oxide, 0.1∼25 wt % tellurium oxide, 1∼28 wt % tungsten oxide, 1∼28 wt % silicon oxide, and 0.1∼20 wt % zinc oxide;
(d) preparing a glass frit (II) which includes 10∼45 wt % lead oxide, 54∼89 wt % tellurium oxide, and 0.1∼10 wt % zinc oxide; and
(e) mixing said vehicle, said conductive metal, said glass frit (I), and said glass frit (II) to form said conductive paste.

7. The method of claim 6, wherein said glass frit (I) further includes at least one element or its oxide consisting of: Sn, P, F, Li, Ba, Al, Mg, Ti, Zr, Pb, V, Se, Mo, W, Ni, Ag, Er, Ge, Ga, Ce, Nb, Sm, and La, of which percentage by weight in the glass frit (I) is 0.1∼3.

8. The method of claim 6, wherein said glass frit (II) may further include at least one element or its oxide consisting of: P, Ba, Al, Mg, Ti, Zr, V, Se, Ag, Er, Yb, Ge, Ga, Ce, Nb, Bi, Li, of which percentage by weight in the glass frit (II) is 0∼10.

9. The method of claim 6, wherein said bismuth oxide, said tellurium oxide, said tungsten oxide, said silicon oxide, and said zinc oxide of said glass frit (I) are Bi₂O₃, TeO₂, WO₃, SiO₂, and ZnO, respectively; and said lead oxide, said tellurium oxide, and said zinc oxide of said glass frit (II) are PbO, TeO₂, and ZnO, respectively.

10. The method of claim 6, further comprising a step of adding at least one additive into said vehicle, wherein said vehicle is an organic vehicle.

## Patentansprüche

1. Eine leitfähige Paste, ist **dadurch gekennzeichnet, dass** sie das Folgende enthält:
ein leitfähiges Metall;
eine Glasfritte (I), die 35 ∼ 70 Gew. % Wismutoxid, 0,1 ∼ 25 Gew. % Telluroxid, 1 ∼ 28 Gew. % Wolframoxid, 1 ∼ 28 Gew. % Siliziumoxid und 0,1 ∼ 20 Gew. % Zinkoxid enthält; und
eine Glasfritte (II), die 10 ∼ 45 Gew. % Bleioxid, 54 ∼ 89 Gew. % Telluroxid und 0,1 ∼ 10 Gew. % Zinkoxid enthält,
wobei die o.a. leitfähige Paste verwendet wird, um Elektrode auf dem Substrat der Solarzelle zu bilden, um den Umwandlungswirkungsgrad zu verbessern.

2. Die leitfähige Paste nach Anspruch 1, worin die o.a. Glasfritte (I) noch mindestens ein folgendes Element oder sein Oxid enthält: Sn, P, F, Li, Ba, Al, Mg, Ti, Zr, Pb, V, Se, Mo, W, Ni, Ag, Er, Ge, Ga, Ce, Nb, Sm und La, dessen Gewichtsprozentsatz in der Glasfritte (I) 0,1 ∼ 3 beträgt.

3. Die leitfähige Paste nach Anspruch 1, worin die o. a. Glasfritte (II) noch mindestens ein folgendes Element oder sein Oxid enthält: P, Ba, Al, Mg, Ti, Zr, V, Se, Ag, Er, Yb, Ge, Ga, Ce, Nb, Bi, und Li, dessen Gewichtsprozentsatz in der Glasfritte (II) 0 ∼ 10 beträgt.

4. Die leitfähige Paste nach Anspruch 1, worin das o. a. Bismutoxid, das o. a. Telluroxid, das o. a. Wolframoxid, das o. a. Siliciumoxid und das o. a. Zinkoxid der o. a. Glasfritte (I) entsprechend Bi₂O₃, TeO₂, WO₃, SiO₂ und ZnO sind; und das Bleioxid, das Telluroxid, und das Zinkoxid der Glasfritte (II) entsprechend PbO, TeO₂ und ZnO sind.

5. Die leitfähige Paste nach Anspruch 1, die noch einen organischen Träger und einen Zusatzstoff enthält.

6. Das Verfahren zur Herstellung einer leitfähigen Paste, ist **dadurch gekennzeichnet, dass** es besteht aus:
(A) Verschaffen eines Trägers;
(B) Verschaffen eines leitfähigen Metalls;
(C) Herstellen einer Glasfritte (I), die 35 ∼ 70 Gew. % Wismutoxid, 0,1 bis 25 Gew. % Telluroxid, 1 ∼ 28 Gew. % Wolframoxid, 1 ∼ 28 Gew. % Siliziumoxid und 0,1 ∼ 20 Gew. % Zinkoxid enthält;
(D) Herstellen einer Glasfritte (II), die 10 ∼ 45 Gew. % Bleioxid, 54 ∼ 89 Gew. % Telluroxid und 0,1 ∼ 10 Gew. % Zinkoxid enthält; und
(E) Gesamtmischung des Trägers, des leitfähigen Metalls, der Glasfritte (I) und der Glasfritte (II), um die leitfähige Paste zu bilden.

7. Das Verfahren nach Anspruch 6, wobei die o.a. Glasfritte (I) noch mindestens ein Element oder sein Oxid enthalten kann, d.h.: Sn, P, F, Li, Ba, Al, Mg, Ti, Zr, Pb, V, Se, Mo, W, Ni, Ag, Er, Ge, Ga, Ce, Nb, Sm und La, dessen Gewichtsprozentsatz in der Glasfritte (I) 0,1 ∼ 3 beträgt.

8. Das Verfahren nach Anspruch 6, wobei die Glasfritte (II) noch mindestens ein Element oder sein Oxid enthalten kann, d. h.: P, Ba, Al, Mg, Ti, Zr, V, Se, Ag, Er, Yb, Ge, Ga, Ce, Nb, Bi, Li, dessen Gewichtsprozentsatz in der Glasfritte (II) 0 ∼ 10 beträgt.

9. Das Verfahren nach Anspruch 6, wobei das Wismutoxid, das Telluroxid, das Wolframoxid, das Siliciumoxid und das Zinkoxid der Glasfritte (I) entsprechend Bi₂O₃, TeO₂, WO₃, SiO₂ und ZnO sind; und das Bleioxid, das Telluroxid und das Zinkoxid der Glasfritte (II) entsprechend PbO, TeO₂ und ZnO sind.

10. Das Verfahren nach Anspruch 6, das noch einen Schritt umfasst, d.h., die Zugabe mindestens eines Additivs in den Träger, wobei der o. a. Träger ein organischer Träger ist.

## Revendications

1. Une pâte conductrice, qui **caractérise en ce qu'**il comprend:
un metal conducteur;
un verre fritté (I), qui comprend 35 à70 % en poids d'oxyde de bismuth, 0.1 à 25 % en poids d'oxyde de tellure, 1 à 28 % en poids d'oxyde de tungstène, 1 à 28 % en poids d'oxyde de silicium et 0.1 à 20 % en poids d'oxyde de zinc; et
un verre fritté (II), qui comprend 10 à 45 % en poids d'oxyde de plomb, 54 à 89 % en poids d'oxyde de tellure et 0.1 à 10 % d'oxyde de zinc,
dans lequel ladite pâte conductrice est utilisée pour former une électrode sur un substrat d'une cellule solaire afin d'améliorer le rendement de conversion.

2. La pâte conductrice selon la revendication 1, dans laquelle ledit verre fritté (I) comprend en outre au moins un élément ou son oxyde consistant en : Sn, P, F, Li, Ba, Al, Mg, Ti, Zr, Pb, V, Se, Mo, W, Ni, Ag, Er, Ge, Ga, Ce, Nb, Sm, et La, dont le pourcentage en poids dans le verre fritté (1) est 0.1 à 3.

3. La pâte conductrice selon la revendication 1, dans laquelle ledit verre fritté (II) peut en outre comprendre au moins un élément ou son oxyde constituant en : P, Ba, Al, Mg, Ti, Zr, V, Se, Ag, Er, Yb, Ge, Ga, Ce, Nb, Bi, et Li, dont le pourcentage en poids dans le verre fritté (II) est de 0 à 10.

4. La pâte conductrice selon la revendication 1, dans laquelle ledit oxyde de bismuth, ledit oxyde de tellure, ledit oxyde de tungstène, ledit oxyde de silicium et ledit oxyde de zinc dudit verre fritté (I) sont respectivement Bi₂O₃, TeO₂, WO₃, SiO₂, et ZnO, et ledit oxyde de plomb, ledit oxyde de tellure et ledit oxyde de zinc dudit verre fritté (II) sont respectivement PbO, TeO₂, et ZnO.

5. La pâte conductrice selon la revendication 1, qui comprend en outre un véhicule organique et un additif.

6. Un procédé de fabrication d'une pâte conductrice, qui caractérise en ce qui comprend:
(a) fourniture d'un véhicule;
(b) fourniture d'un métal conducteur;
(c) préparation d'un verre fritté (I) qui comprend 35 à 70 % en poids d'oxyde de bismuth, 0,1 à 25% en poids d'oxyde de tellure, 1 à 28% en poids d'oxyde de tungstène, 1 à 28 % en poids d'oxyde de silicium et 0,1 à 20% en poids d'oxyde de zinc;
(d) préparation de verre fritté (II) 10 à 45% en poids d'oxyde de plomb, 54 à 89% en poids d'oxyde de tellure et de 0,1 à 10% en poids d'oxyde de zinc; et
(e) mélange dudit véhicule, dudit métal conducteur, dudit verre fritté (I), et dudit verre fritté (II) pour former ladite pâte conductrice.

7. Le procédé selon la revendication 6, dans lequel ledit verre fritté (I) comprend en outre au moins un élément ou son oxyde consistant en : Sn, P, F, Li, Ba, Al, Mg, Ti, Zr, Pb, V, Se, Mo, W, Ni, Ag, Er, Ge, Ga, Ce, Nb, Sm, et La, dont le pourcentage en poids dans ledit verre fritté (I) est 0.1 à 3.

8. Le procédé selon la revendication 6, dans lequel ledit verre fritté (II) peut en outre comprendre au moins un élément ou son oxyde constitué de: P, Ba, Al, Mg, Ti, Zr, V, Se, Ag, Er, Yb, Ge, Ga, Ce, Nb, Bi, Li, dont le pourcentage en poids dudit verre fritté (II) est de 0 à 10.

9. Le procédé selon la revendication 6, dans lequel ledit oxyde de bismuth, ledit oxyde de tellure, ledit oxyde de tungstène, ledit oxyde de silicium, et ledit oxyde de zinc, dudit verre fritté (I) sont respectivement Bai2O3, TeO2, WO, SiO2 et ZnO, et ledit oxyde de plomb, ledit oxyde de tellure, et ledit oxyde de zinc dudit verre fritté (II) sont respectivement PbO, TeO2, et ZnO.

10. Le procédé selon la revendication 6, comprenant en outre une étape consistant à ajouter au moins un additif dans ledit véhicule, dans lequel ledit véhicule est un véhicule organique.
